# EUROPEAN PATENT SPECIFICATION

(11) **EP 1 139 176 B1**
(45) Date of publication and mention of the grant of the patent: **10.05.2006**
(21) Application number: 01302614.1
(22) Date of filing: 21.03.2001
(51) Int. Cl.: G03F 7/20, G03F 1/14

(54) **Lithographic apparatus and mask table**
Lithographisches Gerät und Maskenträger
Appareil lithographique et support de masque

(30) Priority: 24.03.2000 EP 00302420
(43) Date of publication of application: 04.10.2001
(73) Proprietor: ASML Netherlands B.V., 5504 DR Veldhoven (NL)
(72) Inventor: Van Dijsseldonk, Antonius Johannes Josephus, 5527 BH Hapert (NL)
(74) Representative: Leeming, John Gerard

(56) References cited:
- US-A- 4 391 511
- US-A- 4 923 302
- US-A- 5 094 536
- PATENT ABSTRACTS OF JAPAN vol. 1998, no. 03, 27 February 1998 (1998-02-27) & JP 09 306834 A (CANON INC), 28 November 1997 (1997-11-28)
- M. FELDMAN, D. SMITH: "Wafer chuck for magnification correction in x-ray lithography" JOURNAL OF VACUUM SCIENCE AND TECHNOLOGY, NEW YORK, NY, US, vol. B16, no. 6, December 1998 (1998-12), pages 3476-3479, XP002249920

## Description

The present invention relates to a lithographic projection apparatus comprising:
a radiation system for supplying a projection beam of radiation;
a mask table for holding a mask on a mask bearing surface, the mask serving to pattern the projection beam according to a desired pattern;
a substrate table for holding a substrate; and
a projection system for projecting the patterned beam onto a target portion of the substrate.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (*e.g*. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791.

The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. The mask table ensures that the mask can be held at a desired position in the incoming radiation beam, and that it can be moved relative to the beam if so desired.

Conventionally, the mask table has been positioned such that radiation is passed from the illumination system through the mask, the projection system and onto the substrate. Such masks are known as transmissive masks since they selectively allow the radiation from the illumination system to pass through, thereby forming a pattern on the substrate. Such masks must be supported so as to allow the transmission of light therethrough. This has conventionally been achieved by using a vacuum in the table underneath a perimeter zone of the mask so that the atmospheric air pressure clamps the mask to the table.

In a lithographic apparatus the size of features that can be imaged onto the wafer is limited by the wavelength of the projection radiation. To produce integrated circuits with a higher density of devices, and hence higher operating speeds, it is desirable to be able to image smaller features. Whilst most current lithographic projection apparatus employ ultraviolet light generated by mercury lamps or excimer lasers, it has been proposed to use shorter wavelength radiation of around 13 nm. Such radiation is termed extreme ultraviolet (EUV) or soft x-ray and possible sources include laser-produced plasma sources, discharge sources or synchrotron radiation sources.

The abstract of JP 09-306834 discloses supporting an x-ray mask using electrostatic forces.

US 4,391,511 discloses apparatus for applying a force to the back surface of a substrate using a chuck so as to deform the substrate and improve the projected image thereon.

When EUV radiation is used, the projection system will be a non-telecentric on the object side. Therefore, variations in the height of the mask will cause variations in the horizontal and vertical position of the image on the substrate. Also, it is necessary to use a vacuum in the light propagating path to avoid absorption of the light. Thus, the conventional vacuum clamping will not operate.

It is an object of the present invention to provide a lithographic apparatus comprising a mask table that may be used to accurately hold a mask to achieve correct positioning and improved flatness.

This and other objects are achieved according to the invention in a lithographic projection apparatus comprising:
a radiation system for providing a projection beam of radiation;
a mask table for holding a mask on a mask bearing surface, the mask serving to pattern the projection beam according to a desired pattern;
a substrate table for holding a substrate; and
a projection system for projecting the patterned beam onto a target portion of the substrate,
characterized in that said mask table comprises:
   a compliant membrane comprising the mask bearing surface; and
   at least one actuator operable to apply a force to the membrane so as to deform the membrane in a direction substantially perpendicular to the mask bearing surface.

Thus, variations in the surface of a reflective mask can be easily and accurately corrected.

Preferably, the actuators are operable on the backside surface, which opposes the mask bearing surface, of the membrane, and a number of such actuators may be used to increase the preciseness with which the membrane can be deformed. Further, springs may be used between the actuators and membrane so that the forces applied can be tightly controlled.

A mask level sensor may advantageously be used to scan the surface of the mask at a plurality of points so as to construct a three-dimensional map of the mask surface. A controller can then be used to instruct the actuators to provide forces to the membrane such that any irregularities in the mask surface are reduced.

The present invention also provides a lithographic projection apparatus as described above, further comprising a means for attaching a mask to said compliant membrane using an electrostatic force.

According to a further aspect of the invention there is provided a device manufacturing method comprising the steps of:
providing a substrate that is at least partially covered by a layer of radiation-sensitive material;
providing a projection beam of radiation using a radiation system;
using a mask to endow the projection beam with a pattern in its cross-section; and
projecting the patterned beam of radiation onto a target portion of the layer of radiation-sensitive material,
characterized by deforming a compliant membrane comprising a mask bearing surface against which the mask is supported in a direction substantially perpendicular to the mask bearing surface so as to control a shape of the mask.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (*e.g*. with a wavelength of 365, 248, 193, 157 or 126 nm) and extreme ultra-violet (EUV or XUV) radiation (*e.g.* having a wavelength in the range 5-20 nm), as well as particle beams, such as ion beams or electron beams.

Embodiments of the invention will now be described, by way of example only, with reference to the accompanying schematic drawings, in which like reference numerals indicate like parts, and in which:
Figure 1 depicts a lithographic projection apparatus according to an embodiment of the invention;
Figure 2 is a sketch of two possible radiation beam paths showing the effect of varying the mask height; and
Figure 3 is a cross-sectional sketch of a mask table according to the present invention;

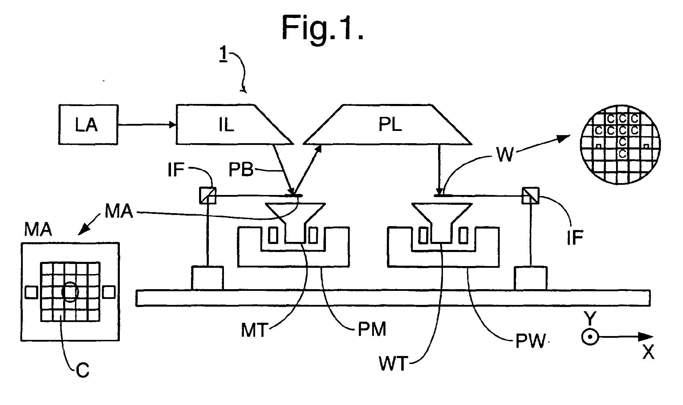

Figure 1 schematically depicts a lithographic projection apparatus 1 according to the present invention. The apparatus comprises:
a radiation system LA, IL for supplying a projection beam PB of EUV radiation;
a first object table (mask table) MT for holding a mask MA (*e.g.* a reticle), and connected to first positioning means PM for accurately positioning the mask with respect to item PL;
a second object table (substrate table) WT for holding a substrate W *(e.g.* a resist-coated silicon wafer), and connected to second positioning means PW for accurately positioning the substrate with respect to item PL;
a projection system ("lens") PL for imaging an irradiated portion of the mask MA onto a target portion C (die) of the substrate W. As here depicted, the projection system is of a reflective type.

The source LA (*e.g.* a laser-produced plasma source, a discharge source, or an undulator or wiggler provided around the path of an electron beam in a storage ring or synchrotron) produces a beam of radiation. This beam is fed into an illumination system (illuminator) IL, either directly or after having traversed conditioning means, such as a beam expander, for example. The illuminator IL may comprise adjusting means for setting the outer and/or inner radial extent (commonly referred to as σ-outer and σ-inner, respectively) of the intensity distribution in the beam. In addition, it will generally comprise various other components, such as an integrator and a condenser. In this way, the beam PB impinging on the mask MA has a desired uniformity and intensity distribution in its cross-section.

It should be noted with regard to Figure 1 that the source LA may be within the housing of the lithographic projection apparatus, but that it may also be remote from the lithographic projection apparatus, the radiation beam which it produces being led into the apparatus (*e.g.* with the aid of suitable directing mirrors). The current invention and claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library or during a scan. In general, movement of the object tables MT, WT will be realized with the aid of a long-stroke module (course positioning) and a short-stroke module (fine positioning), which are not explicitly depicted in Figure 1.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

The present invention *inter alia* alleviates the problem that variations in the height of the mask cause variations in the horizontal position of the final image on the substrate (which will cause overlay errors with respect to previous and/or subsequent layers of a device made).

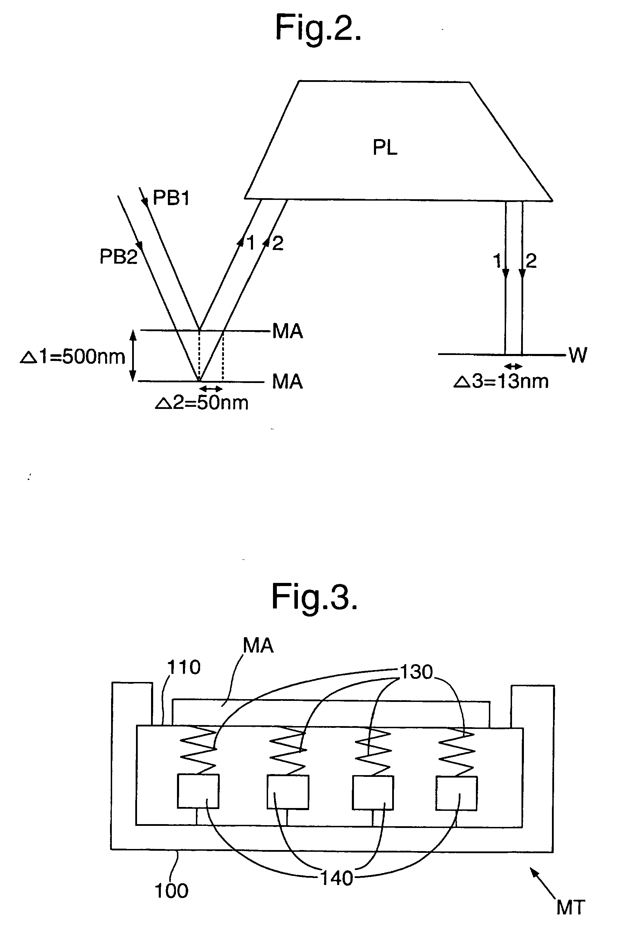

Figure 2 of the accompanying drawings illustrates this phenomenon. Illumination beams PB1 and PB2 impinge on the mask at a fixed angle (of 6° with respect to the surface normal in the embodiment shown). However, variations in the height of the mask mean that the resulting reflected beams will enter the entrance pupil of the projection system at a different position. Reflected beam 1 shown in Figure 2 results when beam PB1 reflects from the mask which is at a first vertical position. If the height position of the mask were to vary (say by Δ1 = 500 nm as shown in Figure 2), the same point on the mask would be struck by beam PB2 and reflected beam 2 would result. The variation in the height of the mask means that the image of the point on the mask at which illumination beams PB1 and PB2 are reflected moves horizontally on the entrance pupil of the projection system (by Δ2 = 500 x tan(6°) = 50 nm in Figure 2). This horizontal movement is scaled in the projection system by an amount corresponding to the magnification factor of the projection system. Thus in Figure 2, the horizontal movement on the wafer is seen as Δ3 = 50 x 0.25 = 13 nm since the magnification factor, in this example, is 0.25. When it is appreciated that many layers must be provided on the wafer with an overlay error of, for example, no more than 3 nm, it can be seen that it is critical to control the height of the mask.

The mask table is shown in greater detail in Figure 3. As can be seen, the table itself comprises a box-like enclosure 100 having a U-shaped configuration in cross-section. A flexible membrane 110 is disposed over the opening in the mask table and the mask MA is attached to the outer surface (the mask bearing suraface) of the membrane. Since a vacuum force cannot be used, the mask is attached to the membrane using electrostatic forces. In other words, the mask and membrane are oppositely charged to create a mutual attraction. The backside of the membrane is attached to a system of springs 130 and actuators 140, which are in turn attached to the bottom of the box-like enclosure 100. The membrane is able to be deformed due to forces which can be applied by the actuators 140. The actuators may be linear actuators such as pistons or linear motors. Further, piezoelectric actuators are suitable. Passive force actuators, such as adjustable springs, adjustable pneumatic cylinders or adjustable balance masses may be used to exert a force on a part of the membrane without the dissipation of heat. Thus, such passive force actuators may advantageously be used in the mask holder of the present invention. The actuators are controlled by a controller (not shown) so that precise forces may be applied to the membrane to ensure that the mask is at the correct vertical position and has good flatness.

The membrane and spring arrangement has an advantage in that any particle backside contamination of the mask is compensated by the flexibility of the membrane and in that it is relatively easy to provide corrective deformation to this construction. In Figure 3, four sets of actuators and springs are used, but this is not intended to be limiting. A higher or lower number could be used, but in general a large number of actuators are advantageous since this allows the membrane to be deformed more precisely.

Masks are manufactured with a high degree of flatness but, nevertheless, deviation of the mask surface from perfect flatness (referred to as "unflatness") of sufficient magnitude noticeably to affect positioning accuracy can occur. Unflatness may be caused, for example, by variations in mask thickness, distortion of the shape of the mask or contaminants on the mask holder. Unless the context otherwise requires, references below to "the mask surface" refer to the top surface of the mask onto which the radiation impinges.

Not shown in Figure 3 is a mask level sensor which measures details of the mask level. The level sensor may be, for example, an optical sensor such as that described in US 5,191,200, incorporated herein by reference, the optical sensor being referred to therein as a focus error detection system, or such as described in European Patent Application EP 1 037 117 (P-0128), incorporated herein by reference. The level sensor may measure the vertical position at a plurality of lateral positions simultaneously and for each may measure the average height of a small area, so averaging out unflatness of high spatial frequencies.

The optical level sensor is able to scan the height of a two-dimensional area by moving a light beam or a group of such beams across the area. The light beams are reflected and the reflected beams are measured to determine the height of the surface at which reflection took place. Only a small area of the surface is mapped at any one time, but since the point of reflection moves as the incident light beam moves, the entire surface can be mapped in a scanning process.

Information from the mask level sensor is used by a controller to determine how to instruct the actuators. For example, when the mask level sensor indicates that part of the mask is too high, the controller would instruct the actuators to move such that that part of the mask is lowered, thereby increasing flatness and improving the average height of the mask. The mask level sensor is one which is capable of taking measurements at a plurality of points on the mask so the controller can cause the actuators to apply forces such that the mask is not only at the correct vertical position, but also has increased flatness. Further, the actuators can correct tilt of the mask, which is important for some applications.

One method according to the present invention is as follows. Firstly, the mask level sensor is used to map the outer surface of the mask so that any irregularities or errors in height can be ascertained. The controller then calculates what forces need to be applied by each of the actuators and controls the actuators accordingly. The actuators may themselves be provided with sensors to detect that they have acted as instructed. In this case, the controller can interrogate the sensors on the actuators to determine whether the actuators have moved by the correct amount. Alternatively, a second scan of the mask surface can be carried out to detect that the adjustment was sufficient in removing irregularities and errors in flatness, tilt and height. This process can be continuous in that the controller constantly checks the surface of the mask with the mask sensor and continuously updates the actuators so that any external variations (for example caused by temperature changes) are continuously monitored and corrected. Alternatively, this process can be carried out just once before exposure of the water.

The invention as described above is described in the context of holding a mask in a lithographic projection apparatus before, during and after a lithographic exposure operation. However, the invention is more generally applicable to any situation in which it is necessary to hold a mask. For example, the mask table (or holder) of the present invention can advantageously be used in a device for making a mask (e-beam writer) because the mask is then perfectly flat during the production of the mask. It is also advantageous to use the mask table of the present invention in a mask (reticle) inspecting device, which is used to inspect the mask for dust, damage or errors.

Whilst we have described above a specific embodiment of the invention it will be appreciated that the invention may be practiced otherwise than as described. The description is not intended to limit the invention.

## Claims

1. A lithographic projection apparatus (1) comprising:
a radiation system (LA,IL) for providing a projection beam (PB) of radiation;
a mask table (MT) for holding a mask (MA) on a mask bearing surface, the mask (MA) serving to pattern the projection beam (PB) according to a desired pattern;
a substrate table (WT) for holding a substrate (W); and
a projection system (PL) for projecting the patterned beam onto a target portion of the substrate (W),
**characterized in that** said mask table (MT) comprises:
a compliant membrane (110) comprising the mask bearing surface; and
at least one actuator (140) operable to apply a force to the membrane (110) so as to deform the membrane (110) in a direction substantially perpendicular to the mask bearing surface.

2. An apparatus according to claim 1, wherein the actuator (140) is operable on a backside surface of the membrane (110), the backside surface opposing the mask bearing surface.

3. An apparatus according to claim 1 or 2, wherein the mask table (MT) further comprises a plurality of actuators (140), each connected to a different part of the membrane (110).

4. An apparatus according to claim 1, 2 or 3, wherein the mask table (MT) further comprises a spring (130) connected to the actuator (140) so as to be operable in series with the actuator (140) on the membrane (110).

5. An apparatus according to claim 4, wherein the spring (130) is arranged between the actuator (140) and the membrane (110).

6. An apparatus according to any one of the preceding claims, further comprising a mask level sensor for measuring a position of a surface of the mask (MA) held on the mask table (MT) in a direction substantially perpendicular to the mask bearing surface.

7. An apparatus according to claim 6, wherein the mask level sensor is constructed and arranged to measure the position at a plurality of different points on the surface of the mask (MA).

8. An apparatus according to claim 6 or 7, further comprising a controller operationally connects to the at least one actuator (140) and the mask level sensor, the controller controlling the at least one actuator (140) so as to keep the mask (MA) at a predetermined level.

9. An apparatus according to claim 6 or 7, further comprising a controller operationally connected to said at least one actuator (140) and the mask level sensor, the controller controlling the at least one actuator (140) so as to increase or preserve the flatness of the surface of the mask (MA).

10. An apparatus according to any one of the preceding claims, further comprising means for attaching the mask (MA) to the compliant membrane (110) using an electrostatic force.

11. An apparatus according to any one of the preceding claims, wherein the mask (MA) is a reflective mask.

12. An apparatus according to any one of the preceding claims, wherein the radiation system (LA,IL) is constructed and arranged to supply a projection beam of radiation having a wavelength of less than 50 nm, especially 5 to 20 nm.

13. An apparatus according to any one of the preceding claims, wherein the radiation system (LA,IL) comprises a radiation source (LA).

14. A mask table (MT) for holding a mask (MA) on a mask bearing surface,
**characterized in that** the mask table (MT) comprises:
a compliant membrane (110) comprising the mask bearing surface; and
at least one actuator (140) operable to apply a force to the membrane (110) so as to deform the membrane (110) in a direction substantially perpendicular to the mask bearing surface.

15. A device manufacturing method comprising the steps of:
providing a substrate (W) that is at least partially covered by a layer of radiation-sensitive material;
providing a projection beam (PB) of radiation using a radiation system (LA,IL);
using a mask (MA) to endow the projection beam (PB) with a pattern in its cross-section; and
projecting the patterned beam of radiation onto a target portion of the layer of radiation-sensitive material,
**characterized by** deforming a compliant membrane (110) comprising a mask bearing surface against which the mask (MA) is supported in a direction substantially perpendicular to the mask bearing surface so as to control a shape of the mask (MA).

## Patentansprüche

1. Lithographische Projektionsvorrichtung (1), umfassend:
ein Strahlungssystem (LA, IL) zum Bereitstellen eines Projektionsstrahls (PB) aus Strahlung;
einen Maskentisch (MT) zum Halten einer Maske (MA) auf einer maskentragenden Fläche, wobei die Maske (MA) dazu dient, den Projektionsstrahl (PB) mit einem gewünschten Muster zu prägen;
einen Substrattisch (WT) zum Halten eines Substrats (W); und
ein Projektionssystem (PL) zum Projizieren des geprägten Strahls auf einen Zielabschnitt des Substrats (W),
**dadurch gekennzeichnet, dass** der Maskentisch (MT) umfasst:
eine die maskentragende Fläche umfassende weichelastische Membran (110); und
mindestens einen Aktuator (140), der dazu funktionsfähig ist, eine Kraft auf die Membran (110) auszuüben, um die Membran (110) in eine Richtung im Wesentlichen rechtwinklig zu der maskentragenden Fläche zu deformieren.

2. Vorrichtung nach Anspruch 1, wobei der Aktuator (110) auf einer hinteren Fläche der Membran (110) funktionsfähig ist, wobei die hintere Fläche der maskentragenden Fläche gegenüber liegt.

3. Vorrichtung nach Anspruch 1 oder 2, wobei der Maskentisch (MT) weiterhin eine Mehrzahl von Aktuatoren (140) umfasst, von denen jeder mit einem anderen Teil der Membran (110) verbunden ist.

4. Vorrichtung nach Anspruch 1, 2 oder 3, wobei der Maskentisch (MT) weiterhin eine mit dem Aktuator (140) verbundene Feder (130) umfasst, die in Serie mit dem Aktuator (140) auf die Membran (110) wirkfähig ist.

5. Vorrichtung nach Anspruch 4, wobei die Feder (130) zwischen dem Aktuator (140) und der Membran (110) angeordnet ist.

6. Vorrichtung nach einem der voranstehenden Ansprüche, weiterhin einen Maskenniveausensor zum Messen einer Position einer Fläche der auf dem Maskentisch (MT) gehaltenen Maske (MA) in einer Richtung im Wesentlichen rechtwinklig zu der maskentragenden Fläche umfassend.

7. Vorrichtung nach Anspruch 6, wobei der Maskenniveausensor dazu ausgebildet und angeordnet ist, die Position an einer Mehrzahl verschiedener Punkte auf der Fläche der Maske (MA) zu messen.

8. Vorrichtung nach Anspruch 6 oder 7, weiterhin eine betriebsfähig mit dem mindestens einen Aktuator (140) und dem Maskenniveausensor verbundene Steuereinrichtung umfassend, wobei die Steuereinrichtung den mindestens einen Aktuator (140) so steuert, dass die Maske (MA) auf einem vorbestimmten Niveau gehalten wird.

9. Vorrichtung nach Anspruch 6 oder 7, weiterhin eine betriebsfähig mit dem mindestens einen Aktuator (140) und dem Maskenniveausensor verbundene Steuereinrichtung umfassend, wobei die Steuereinrichtung den mindestens einen Aktuator (140) so steuert, dass die Flachheit der Fläche der Maske (MA) vergrößert oder erhalten wird.

10. Vorrichtung nach einem der voranstehenden Ansprüche, weiterhin Mittel zum Anfügen der Maske (MA) an die weichelastische Membran (110) umfassend, die eine elektrostatische Kraft verwenden.

11. Vorrichtung nach einem der voranstehenden Ansprüche, wobei die Maske (MA) eine reflektierende Maske ist.

12. Vorrichtung nach einem der voranstehenden Ansprüche, wobei das Strahlungssystem (LA, IL) ausgebildet und angeordnet ist, einen Projektionsstrahl mit einer Wellenlänge von weniger als 50 nm, insbesondere 5 bis 20 nm, bereitzustellen.

13. Vorrichtung nach einem der voranstehenden Ansprüche, wobei das Strahlungssystem (LA, IL) eine Strahlungsquelle (LA) umfasst.

14. Maskentisch (MT) zum Halten einer Maske (MA) auf einer maskentragenden Fläche, **dadurch gekennzeichnet, dass** der Maskentisch (MT) umfasst:
eine die maskentragende Fläche umfassende weichelastische Membran (110); und
mindestens einen Aktuator (140) der funktionsfähig ist, eine Kraft auf die Membran (110) auszuüben, um die Membran in eine Richtung im Wesentlichen rechtwinklig zu der maskentragenden Fläche zu deformieren.

15. Verfahren zum Herstellen einer Vorrichtung, die Schritte umfassend:
Bereitstellen eines mindestens teilweise durch eine Schicht von strahlungsempfindlichen Material bedeckten Substrats (W);
Bereitstellen eines Projektionsstrahls (PB) mittels eines Strahlungssystems (LA, IL);
Verwenden einer Maske (MA), um den Projektionsstrahl (PB) mit einem Muster in seinem Querschnitt zu versehen; und
Projizieren des geprägten Strahls auf einen Zielabschnitt der Schicht aus strahlungsempfindlichem Material,
**dadurch gekennzeichnet, dass** eine weichelastische Membran (110) deformiert wird, die eine maskentragende Fläche umfasst, gegen die die Maske (MA) in eine Richtung im Wesentlichen rechtwinklig zu der maskentragenden Fläche gestützt wird, um eine Form der Maske (MA) zu steuern.

## Revendications

1. Appareil de projection lithographique (1) comportant :
un système de rayonnement (LA, IL) pour délivrer un faisceau de projection (PB) de rayonnement ;
une table de masque (MT) pour maintenir un masque (MA) sur une surface de support de masque, le masque (MA) servant à mettre en forme le faisceau de projection (PB) conformément à un motif voulu ;
une table de substrat (WT) pour maintenir un substrat (W) ; et
un système de projection (PL) pour projeter le faisceau mis en forme sur une partie cible du substrat (W),
**caractérisé en ce que** ladite table de masque (MT) comporte :
une membrane souple (110) comportant la surface de support de masque ; et
au moins un actionneur (140) opérationnel pour appliquer une force à la membrane (110) de manière à déformer la membrane (110) dans une direction essentiellement perpendiculaire à la surface de support de masque.

2. Appareil selon la revendication 1, dans lequel l'actionneur (140) est opérationnel sur une surface arrière de la membrane (110), la surface arrière étant en vis-à-vis de la surface de support de masque.

3. Appareil selon la revendication 1 ou 2, dans lequel la table de masque (MT) comporte de plus une pluralité d'actionneurs (140), chacun connecté à une partie différente de la membrane (110).

4. Appareil selon la revendication 1, 2 ou 3, dans lequel la table de masque (MT) comporte de plus un ressort (130) relié à l'actionneur (140) de manière à être opérationnel en série avec l'actionneur (140) sur la membrane (110).

5. Appareil selon la revendication 4, dans lequel le ressort (130) est agencé entre l'actionneur (140) et la membrane (110).

6. Appareil selon l'une quelconque des revendications précédentes, comportant de plus un capteur de niveau de masque pour mesurer une position d'une surface du masque (MA) maintenu sur la table de masque (MT) dans une direction essentiellement perpendiculaire à la surface de support de masque.

7. Appareil selon la revendication 6, dans lequel le capteur de niveau de masque est conçu et agencé pour mesurer la position d'une pluralité de points différents sur la surface du masque (MA).

8. Appareil selon la revendication 6 ou 7, comportant de plus un contrôleur relié de manière opérationnelle à au moins un actionneur (140) et au capteur de niveau de masque, le contrôleur commandant le au moins un actionneur (140) de manière à maintenir le masque (MA) à un niveau prédéterminé.

9. Appareil selon la revendication 6 ou 7, comportant de plus un contrôleur relié de manière opérationnelle à au moins un actionneur (140) et au capteur de niveau de masque, le contrôleur commandant le au moins un actionneur (140) de manière à augmenter ou préserver la planéité de la surface du masque (MA).

10. Appareil selon l'une quelconque des revendications précédentes, comportant de plus des moyens pour attacher le masque (MA) à la membrane souple (110) en utilisant une force électrostatique.

11. Appareil selon l'une quelconque des revendications précédentes, dans lequel le masque (MA) est un masque réflecteur.

12. Appareil selon l'une quelconque des revendications précédentes, dans lequel le système de rayonnement (LA, IL) est construit et agencé pour délivrer un faisceau de projection de rayonnement ayant une longueur d'onde inférieure à 50 nm, en particulier de 5 à 20 nm.

13. Appareil selon l'une quelconque des revendications précédentes, dans lequel le système de rayonnement (LA, IL) comporte une source de rayonnement (LA).

14. Table de masque (MT) pour maintenir un masque (MA) sur une surface de support de masque, **caractérisée en ce que** la table de masque (MT) comporte :
une membrane souple (110) comportant la surface de support de masque ; et
au moins un actionneur (140) opérationnel pour appliquer une force à la membrane (110) de manière à déformer la membrane (110) dans une direction essentiellement perpendiculaire à la surface de support de masque.

15. Procédé de fabrication d'un dispositif, comportant les étapes consistant à :
fournir un substrat (W) qui est au moins partiellement recouvert d'une couche de matériau sensible au rayonnement ;
délivrer un faisceau de projection (PB) de rayonnement en utilisant un système de rayonnement (LA, IL) ;
utiliser un masque (MA) pour doter le faisceau de projection (PB) d'une configuration dans sa section transversale ; et
projeter le faisceau de rayonnement mis en forme sur une partie cible de la couche du matériau sensible au rayonnement,
**caractérisé par** la déformation d'une membrane souple (110) comportant une surface de support de masque contre laquelle le masque (MA) est supporté dans une direction essentiellement perpendiculaire à la surface de support de masque de manière à commander une forme du masque (MA).
